# EUROPÄISCHE PATENTSCHRIFT

(11) **EP 0 632 681 B1**
(45) Veröffentlichungstag und Bekanntmachung des Hinweises auf die Patenterteilung: **16.07.1997**
(21) Anmeldenummer: 94107880.0
(22) Anmeldetag: 21.05.1994
(51) Int. Cl.: H05K 1/02

(54) **Metallbeschichtetes Substrat**
Metal-coated substrate
Substrat revêtu de métal

(30) Priorität: 02.06.1993 DE 4318241
(43) Veröffentlichungstag der Anmeldung: 04.01.1995
(73) Patentinhaber: Schulz-Harder, Jürgen, Dr.-Ing., D-91207 Lauf (DE)
(72) Erfinder: Schulz-Harder, Jürgen, Dr.-Ing., D-91207 Lauf (DE)
(74) Vertreter: Graf, Helmut, Dipl.-Ing.

(56) Entgegenhaltungen:
- DE-C- 3 728 096
- DE-C- 4 004 844
- PATENT ABSTRACTS OF JAPAN, Bd. 15 Nr. 367 (E-1112) ,17.September 1991 & JP-A-03 145748
- PATENT ABSTRACTS OF JAPAN, Bd. 17 Nr. 337 (E-1388) ,25.Juni 1993 & JP-A-05 041566

## Beschreibung

Die Erfindung bezieht sich auf ein Substrat gemäß Oberbegriff Patentanspruch 1.

Insbesondere auch Keramiksubstrate sind in den unterschiedlichsten Ausführungen bekannt und werden bevorzugt für elektrische Leistungsschaltkreise bzw. -module verwendet.

In vielen Anwendungen unterliegen solche Keramiksubstrate hohen Temperaturwechselbelastungen, bei denen Temperaturänderungen im Bereich zwischen - 40°C und + 125°C durchaus auftreten können.

Bedingt durch den unterschiedlichen Wärmeausdehnungskoeffizienten der Keramikschicht und Metallschicht ergeben sich am Übergang zwischen diesen Schichten bei Temperaturschwankungen erhebliche mechanische Druck- oder Zugspannungen, deren Gradient im Keramikmaterial am Rand der Metallschicht besonders groß ist und zu Rissen im Bereich der Oberfläche der Keramikschicht führt.

Es ist bekannt, daß durch eine Strukturierung der Metallschicht, die (Strukturierung) vielfach bereits durch das für den Schaltkreis notwendige Layout vorgegeben ist, der Gradient der Zug- und Druckspannungen verringert werden kann.

Vorgeschlagen wurde auch bereits (DE 40 04 844) durch Ätztechniken eine strukturierte Metallisierung zu schaffen, die an ihren Rändern zur Reduzierung des Gradienten der Zug-und Druckspannungen stellenweise geschwächt ist. Die hierbei vermittelte Lehre umfaßt in ihrer allgemein gehaltenen Form auch bereits vorher bekannte Ausgestaltungen von Leiterbahnen, Kontaktflächen oder dergl. strukturierten Metallisierungen sowie auch Kantenabschwächungen, wie sie beim Ätzen von Strukturen von Metallisierungen zwangsläufig erhalten werden und sich nicht vermeiden lassen.

Aufgabe der Erfindung ist es, ein metallbeschichtetes Substrat aufzuzeigen, welches sich durch eine verbesserte Lebensdauer auszeichnet und bei dem auch bei einer großen Dicke der Metallschicht Risse am Rand dieser Schicht selbst bei einer hohen Anzahl von Temperaturwechselbelastungen besonders wirksam verhindert sind.

Zur Lösung dieser Aufgabe ist ein metallbeschichtetes Substrat entsprechend dem kennzeichnenden Teil des Patentanspruches 1 ausgebildet.

Durch die erfindungsgemäße Ausgestaltung, d. h. durch die spezielle Schwächung der Metallschicht im Bereich ihres Randes durch zwei Reihen von Öffnungen, wird eine besonders günstige Verteilung der Druck- und Zugspannungen erreicht, so daß auch bei sehr dicken Metallschichten, d. h. bei Metallschichten, deren Dicke wenigstens 0,2 mm, bevorzugt jedoch größer ist, und bei einer hohen Anzahl von Temperaturwechselbelastungen durch Zug- und Druckspannungen bedingte Risse wirksam verhindert sind.

Weiterbildungen der Erfindung sind Gegenstand der Unteransprüche.

Die Erfindung wird in folgenden anhand der Figuren an Ausführungsbeispielen näher erläutert. Es zeigen:
- Fig. 1: in Teildarstellung und in Draufsicht ein Keramiksubstrat gemäß der Erfindung;
- Fig. 2: einen Schnitt entsprechend der Linie I - I;
- Fig. 3: in ähnlicher Darstellung wie Fig. 2 eine Metallkernplatte.

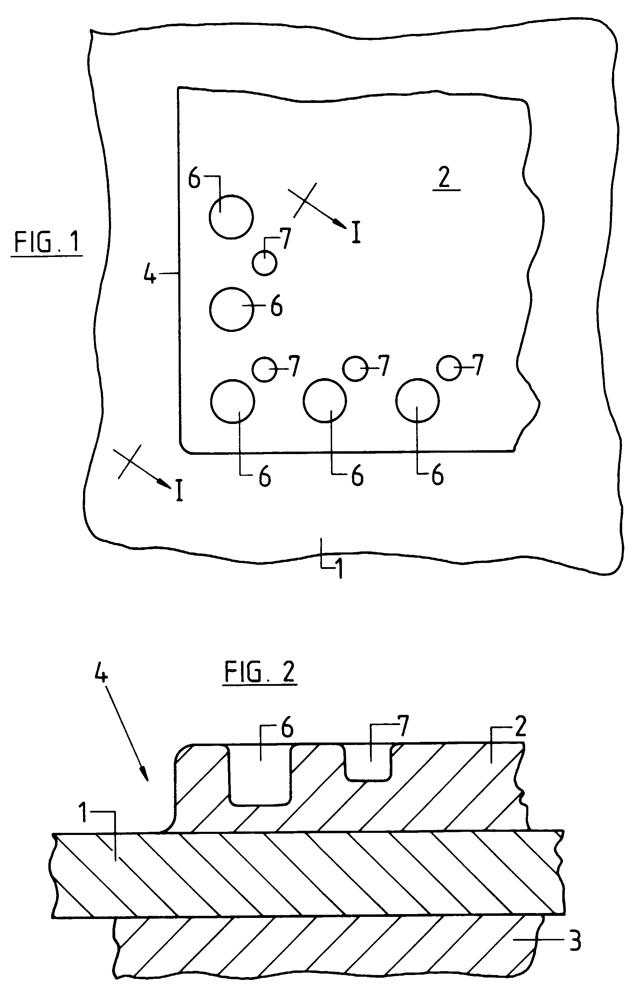

In der Figur 1 ist ein Teil eines Keramiksubstrates dargestellt, welches im wesentlichen aus einer Keramikschicht 1, beispielsweise aus einer Aluminiumoxid-Keramik oder einer Aluminiumnitrid-Keramik, sowie aus Metallschichten 2 und 3, beispielsweise aus Kupferschichten besteht, von denen die Metallschicht 2 an der Oberseite und die Metallschicht 3 an der Unterseite der Keramikschicht 1 vorgesehen ist.

Zumindest die Metallschicht 2 weist eine Dicke von wenigstens 0,2 mm. Beide Metallschichten sind jeweils mit einer Oberflächenseite der Keramikschicht 1 flächig verbunden, und zwar beispielsweise mittels des dem Fachmann bekannten und in der Literatur mehrfach beschriebenen DCB-Verfahrens oder Aktivlot-Verfahrens.

Das Keramiksubstrat ist Teil eines elektrischen Leistungs-Schaltkreises bzw. -Moduls. Die obere Metallschicht 2 ist durch bekannte Techniken (z.B. Ätztechniken) strukturiert und bildet Leiterbahnen sowie auch metallisierte Kontaktflächen, auf denen die nicht dargestellten Leistungs-Bauelemente befestigt sind, deren Verlustwärme über die Metallschicht 2, die Keramikschicht 1 und die weitere Metallschicht 3 an einem nicht dargestellten Kühlkörper abgeleitet wird.

In vielen Anwendungen, beispielsweise auch in der Kraftfahrzeugelektronik, unterliegen Keramik-Substrate erheblichen Temperaturwechselbelastungen, bei denen die Temperaturschwankungen zwischen - 60°C und + 125°C liegen können. Insbesondere dann, wenn die Metallisierung 2 eine Dicke aufweist, die größer als 0,2 mm ist, um so Leiterbahnen realisieren zu können, die einen für die hohen Ströme eines Leistungsmoduls ausreichenden Querschnitt gewährleisten, kann es entlang des Randes 4 der Metallschicht 2 bzw. der von dieser gebildeten Strukturen im Bereich der Oberfläche der Keramikschicht 1 zu Rissen und damit zu einem Lösen der Metallschicht 2 kommen. Diese Risse sind darauf zurückzuführen, daß es beim Abkühlen oder Erwärmen des Substrates -bedingt durch durch den unterschiedlichen Wäremeausdehnungskoeffizienten des Metalls der Metallschicht 2 und der Keramik der Keramikschicht 1 - am Übergang zwischen der Metallschicht 2 und der Keramikschicht 1 zu mechanischen Druck- und Zugkspannungen kommt, wobei der Gradient des Spannungsverlaufs, also die Änderung der jeweiligen Druck-und Zugspannung am Rand 4 besonders groß ist.

Um diesen Gradienten am Übergang von der Metallschicht 2 zur Keramikschicht 1 insbesondere auch im Bereich des Randes 4 zu mindern, sind in der Metallschicht 2 entlang des Randes 4 mehrere Öffnungen 6 und 7 in zwei Reihen eingebracht, von denen die Öffnungen 6 die erste, dem Rand 4 näherliegende Reihe und die Öffnungen 7 die zweite, vom Rand 4 weiter beabstandete Reihe bilden.

Die Öffnungen 6 und 7, die bei der dargestellten Ausführungsform jeweils den gleichen Querschnitt besitzen, sind von der der Keramikschicht 1 abgewandten Oberseite der Metallschicht 2 in diese mit geeigneten, bekannten Techniken, beispielsweise mit Ätztechniken, derart eingebracht, daß die Öffnungen 6 entweder ganz durchgehend sind, d.h. der Boden dieser Öffnungen von der Oberseite der Keramikschicht 1 gebildet ist, oder aber zwischen dem Boden der Öffnungen 6 und der Oberseite der Keramikschicht 1 den Abstand verbleibt, der etwa einem Drittel der Dicke der Metallschicht 2 entspricht.

Die Öffnungen 7 besitzen eine im Vergleich zu den Öffnungen 6 geringere Tiefe und sind soweit in die Metallschicht 2 eingebracht, daß der Abstand zwischen dem Boden dieser Öffnungen und der Oberseite der Keramikschicht 1 etwa im Bereich zwischen einem Drittel der Dicke der Metallschicht 2 und der Hälfte dieser Dicke liegt.

Der Abstand der Öffnungen 6 und 7 liegt etwa zwischen der Hälfte und dem 3-Fachen des Radius dieser Öffnungen. Der Durchmesser der Öffnungen 6 und 7 liegt im Bereich zwischen dem 0,5 - 2,5-Fachen der Dicke der Metallschicht. Hierbei ist auch eine Überlappung der Öffnungen 6 bzw. 7 möglich.

Bei der dargestellten Ausführungsform sind die Öffnungen 6 und 7 weiterhin auf Lücke derart versetzt, daß sich entlang der Reihen jeweils eine Öffnung 7 zwischen zwei Öffnungen 6 befindet. Die beiden Reihen der Öffnungen 6 und 7 sind in einen streifenförmigen Bereich entlang des Randes 4 vorgesehen, dessen Breite höchstens 2 mm ist.

Durch die Öffnungen 6 und 7 ergibt sich eine wesentliche Verringerung des Gradienten der Druck- und Zugspannungen zwischen Keramikschicht 1 und der Metallschicht 2 entlang des Randes 4, womit die Entstehung von Rissen 5 auch bei einer hohen Anzahl von Temperaturwechselbelastungen mit extremen Temperaturunterschieden wirksam vermieden wird.

Bei der in den Figuren 1 und 2 dargestellten Ausführungsform besitzen die dem Rand 4 näherliegenden Öffnungen 6 einen Querschnitt, der größer ist als der Querschnitt der Öffnungen 7.

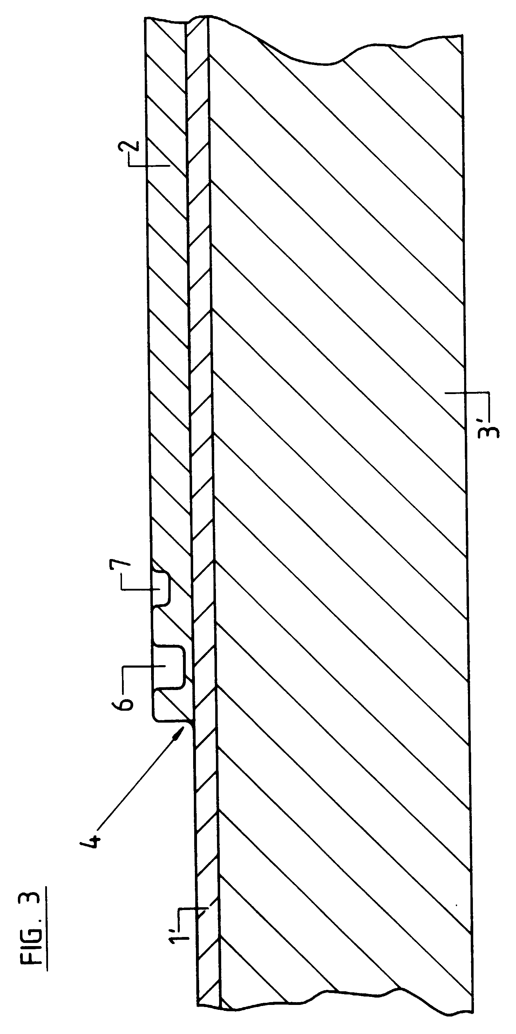

Fig. 3 zeigt in vereinfachter Darstellung und im Teilschnitt noch eine Metallkernplatte, die aus der oberen Kupferschicht 3, einer isolierenden Schicht 1' mit einer Dicke von etwa 20 - 10 Mikrometern sowie aus einer dicken Metallschicht bzw. Platte 3' besteht, die beispielsweise aus Aluminium hergestellt ist. Die Kupferschicht 2' ist wiederum entlang des Randes mit den Öffnungen 6 und 7 versehen.
Die Erfindung wurde voranstehend an einem Ausführungsbeispiel beschrieben. Es versteht sich, daß zahlreiche Änderungen sowie Abwandlungen möglich sind, ohne daß dadurch der der Erfindung zugrundeliegende Erfindungsgedanke verlassen wird.

So ist es beispielsweise möglich, daß die Öffnungen 6 und 7 in den beiden Reihen, aber auch von Reihe zu Reihe jeweils unterschiedliche Größen bzw. Querschnitt und/oder unterschiedliche Tiefen aufweisen, wobei aber die Tiefe der Öffnungen 6 stets größer ist als die Tiefe benachbarter Öffnungen 7. Weiterhin ist es auch möglich, daß die Öffnung 6 und/oder 7 einen von der Kreisform abweichenden Querschnitt besitzen.

Bei der vorstehenden Beschreibung wurde der Einfachheit halber davon ausgegangen, daß die Öffnungen 6 und 7 lediglich am Rand 4 der Metallschicht 2 vorgesehen sind. Selbstverständlich können entsprechende Öffnungen auch am Rand der Metallschicht 3 vorgesehen sein.

Bei der in den Fig. 1 und 2 dargestellten Ausführungsform sind die von den Öffnungen 6 und 7 gebildeten Reihen derart voneinander beabstandet und der Querschnitt dieser Öffnungen ist so gewählt, daß sich die Reihen der Öffnungen überlappen.

### Bezugszeichenliste

- 1: Keramikschicht
- 1': isolierende Schicht
- 2, 3: Metallschicht
- 3': Metallschicht
- 4: Rand
- 5: Riß
- 6, 7: Öffnung

## Patentansprüche

1. Metallbeschichtetes Substrat mit verbesserter Widerstandsfähigkeit gegen Temperaturwechselbeanspruchung, bestehend aus wenigstens einer isolierenden Schicht (1, 1') sowie aus wenigstens einer an mindestens einer Oberflächenseite der isolierenden Schicht (1, 1') flächig befestigten Metallschicht (2, 3), deren Dicke wenigstens 0,2 mm beträgt und die an wenigstens einem Randbereich (4) eine stellenweise Schwächung durch in die Metallschicht eingebrachte Öffnungen (6, 7) aufweist, dadurch gekennzeichnet, daß die Öffnungen (6, 7) entlang und in der Nähe des Randbereichs zwei Reihen bilden, daß die Öffnungen (6) einer ersten, dem Rand (4) näher liegenden Reihe eine größere Tiefe als die Öffnungen (7) einer zweiten, dem Rand (4) entfernter liegenden Reihe aufweisen, daß der Boden der ersten Öffnungen (6) einen Abstand von der isolierenden S chicht aufweist, der kleiner als ein Drittel der Dicke der Metallschicht (2) ist, und daß der Boden der Öffnungen (7) der zweiten Reihe einen Abstand von der Oberflächenseite der isolierenden Schicht (1, 1') aufweist, der zwischen einem Drittel und der Hälfte der Dicke der Metallschicht (2) liegt.

2. Substrat nach Anspruch 1, dadurch gekennzeichnet, daß die Reihen maximal um das 10-Fachen bis 30-Fachen der Dicke Metallschicht (2, 3), vorzugsweise maximal 2 mm vom Rand (4) beabstandet sind.

3. Metallbeschichtetes Substrat mit verbesserter Widerstandsfähigkeit gegen Temperaturwechselbeanspruchung, bestehend aus wenigstens einer isolierenden Schicht (1, 1') sowie aus wenigstens einer an mindestens einer Oberflächenseite der isolierenden Schicht (1, 1') flächig befestigten Metallschicht (2, 3), deren Dicke wenigstens 0,2 mm beträgt und die an wenigstens einem Randbereich (4) eine stellenweise Schwächung durch in die Metallschicht eingebrachte Öffnungen (6, 7) aufweist, dadurch gekennzeichnet, daß die Öffnungen (6, 7) entlang des Randbereichs zwei Reihen bilden, die maximal 2 mm vom Rand (4) beabstandet sind, daß die Öffnungen (6) einer ersten, dem Rand (4) näher liegenden Reihe eine größere Tiefe als die Öffnungen (7) einer zweiten, dem Rand (4) entfernter liegenden Reihe aufweisen, daß der Boden der ersten Öffnungen (6) einen Abstand von der isolierenden S chicht aufweist, der kleiner als ein Drittel der Dicke der Metallschicht (2) ist, und daß der Boden der Öffnungen (7) der zweiten Reihe einen Abstand von der Oberflächenseite der isolierenden Schicht (1, 1') aufweist, der zwischen einem Drittel und der Hälfte der Dicke der Metallschicht (2) liegt.

4. Substrat nach einem der Ansprüche 1 - 3, dadurch gekennzeichnet, daß die Öffnungen (6, 7) beider Reihen jeweils gleichen Querschnitt aufweisen.

5. Substrat nach einem der Ansprüche 1 - 4, dadurch gekennzeichnet, daß die Öffnungen (6, 7) beider Reihen schiedlichen Querschnitt aufweisen.

6. Substrat nach einem der Ansprüche 1 - 5, dadurch gekennzeichnet, daß die Öffnungen (6, 7) der beiden Reihen auf Lücke versetzt sind.

7. Substrat nach einem der Ansprüche 1 - 6, dadurch gekennzeichnet, daß die isolierende Schicht eine Keramikschicht (1) ist.

8. Substrat nach einem der Ansprüche 1 - 7, dadurch gekennzeichnet, daß die isolierende Schicht (1') aus einem Kunststoffmaterial, beispielsweise aus einem für Leiterplatten üblicherweise verwendeten Kunststoffmaterial (GFK-Leiterplattenmaterial) besteht.

9. Substrat nach einem der Ansprüche 1 - 8, dadurch gekennzeichnet, daß die isolierende Schicht (1') aus einem Kunststoffmaterial besteht und mit einer weiteren Metallträgerplatte (3') flächig verbunden ist.

10. Substrat nach einem der Ansprüche 1 - 9, dadurch gekennzeichnet, daß der Querschnitt der Öffnungen (6, 7) etwa dem 0,5 - 3-Fachen der Dicke der wenigstens einen Metallschicht(2) entspricht.

## Claims

1. Metal-coated substrate with improved resistance to thermal cycling, consisting of at least one insulating layer (1, 1') and of at least one metal layer (2,3) fixed flat to at least one surface side of the insulating layer (1, 1'), whose thickness is at least 0.2 mm and which displays a weakening in parts in at least one edge area (4) through openings (6, 7) made in the metal layer, characterised in that the openings (6, 7) form two rows along and close to the edge area, that the openings (6) of a first row lying closer to the edge (4) display a greater depth than the openings (7) of a second row lying further from the edge (4), that the base of the first openings (6) displays a distance from the insulating layer which is less than one third of the thickness of the metal layer (2), and that the base of the openings (7) of the second row display a distance from the surface side of the insulating layer (1, 1') which is between one third and half of the thickness of the metal layer (2).

2. Substrate according to claim 1, characterised in that the rows are at a distance from the edge (4) of 10 to 30 times the thickness of the metal layer (2, 3), preferably a maximum of 2 mm.

3. Metal-coated substrate with improved resistance to thermal cycling, consisting of at least one insulating layer (1, 1') and of at least one metal layer (2,3) fixed flat to at least one surface side of the insulating layer (1, 1'), whose thickness is at least 0.2 mm and which displays a weakening in parts in at least one edge area (4) through openings (6, 7) made in the metal layer, characterised in that the openings (6, 7) form two rows along the edge area, which are at a maximum distance of 2 mm from the edge (4), that the openings (6) of a first row lying closer to the edge (4) display a greater depth than the openings (7) of a second row lying further from the edge (4), that the base of the first openings (6) displays a distance from the insulating layer which is less than one third of the thickness of the metal layer (2), and that the base of the openings (7) of the second row display a distance from the surface side of the insulating layer (1,1') which is between one third and half of the thickness of the metal layer (2).

4. Substrate according to one of claims 1 - 3, characterised in that the openings (6, 7) of both rows display the same profile.

5. Substrate according to one of claims 1 - 4, characterised in that the openings (6, 7) of both rows display different profiles.

6. Substrate according to one of claims 1 - 5, characterised in that the openings (6, 7) of both rows are staggered.

7. Substrate according to one of claims 1 - 6, characterised in that the insulating layer is a ceramic layer (1).

8. Substrate according to one of claims 1 - 7, characterised in that the insulating layer (1') consists of a plastic material, for example of a plastic material customarily used for printed circuit boards (glass-fibre reinforced printed circuit board material).

9. Substrate according to one of claims 1 - 8, characterised in that the insulating layer (1') consists of a plastic material and is connected flat with a further metal backplate (3').

10. Substrate according to one of claims 1 - 9, characterised in that the profile of the openings (6, 7) corresponds to approximately 0.5 - 3 times the thickness of the at least one metal layer (2).

## Revendications

1. Substrat recouvert de métal avec une meilleure capacité de résistance aux changements de température, composé au moins d'une couche isolante (1, 1) de même que au moins une couche métallique (2, 3) fixée à plat sur au moins un côté superficiel de la couche isolante (1, 1'), couche métallique dont l'épaisseur atteint au moins 0,2 mm et qui, sur au moins une zone du bord (4), présente un affaiblissement partiel du fait d'ouvertures (6, 7) pratiquées dans la couche métallique, **caractérisé en ce que** les ouvertures (6, 7) le long et à proximité de la zone du bord forment deux rangées, en ce que les ouvertures (6) d'une première rangée proche du bord (4) présentent une profondeur plus grande que les ouvertures (7) d'une seconde rangée éloignée du bord (4), en ce que le fond des premières ouvertures (6) présente un écart par rapport à la couche isolante qui est plus petit qu'un tiers de l'épaisseur de la couche métallique (2), et en ce que le fond des ouvertures (7) de la seconde rangée présente un écart par rapport au côté superficiel de la couche isolante (1, 1') qui se situe entre un tiers et la moitié de l'épaisseur de la couche métallique (2).

2. Substrat suivant la revendication 1, caractérisé en ce que les rangées sont espacées au maximum de 10 à 30 fois l'épaisseur de la couche métallique (2, 3), préférentiellement de maximum 2 mm par rapport au bord (4).

3. Substrat recouvert de métal avec une meilleure capacité de résistance aux changements de température, composé au moins d'une couche isolante (1, 1') de même que au moins une couche métallique (2,3) fixée à plat sur au moins un côté superficiel de la couche isolante (1, 1'), couche métallique dont l'épaisseur atteint au moins 0,2 mm et qui, sur moins une zone du bord (4), présente un affaiblissement partiel du fait d'ouvertures (6, 7) pratiquées dans la couche métallique, caractérisé en ce que les ouvertures (6, 7) le long de la zone du bord forment deux rangées qui sont espacées au maximum de 2 mm du bord (4), en ce que les ouvertures (6) d'une première rangée proche du bord (4) présentent une profondeur plus grande que les ouvertures (7) d'une seconde rangée éloignée du bord (4), en ce que le fond des premières ouvertures (6) présente un écart par rapport à la couche isolante qui est plus petit qu'un tiers de l'épaisseur de la couche métallique (2), et en ce que le fond des ouvertures (7) de la seconde rangée présente un écart par rapport au côté superficiel de la couche isolante (1, 1') qui se situe entre un tiers et la moitié de l'épaisseur de la couche métallique (2).

4. Substrat suivant l'une ou l'autre de revendications 1 à 3, caractérisé en ce que les ouvertures (6, 7) des deux rangées présentent la même section transversale.

5. Substrat suivant l'une ou l'autre de revendications 1 à 4, caractérisé en ce que les ouvertures (6, 7) des deux rangées présentent une section transversale différente.

6. Substrat suivant l'une ou l'autre de revendications 1 à 5, caractérisé en ce que les ouvertures (6, 7) des deux rangées sont décalées.

7. Substrat suivant l'une ou l'autre de revendications 1 à 6, caractérisé en ce que la couche isolante est une couche céramique (1).

8. Substrat suivant l'une ou l'autre de revendications 1 à 7, carctérisé en ce que la couche isolante (1') se compose d'un matériau plastique, par exemple d'un matériau plastique utilisé couramment pour des plaquettes pour circuits imprimés (matériau pour plaquettes en fibres de verre imprégnées).

9. Substrat suivant l'une ou l'autre de revendications 1 à 8, caractérisé en ce que la couche isolante (1') se compose d'un matériau plastique et est connecté à plat à une autre plaque portante métallique (3').

10. Substrat suivant l'une ou l'autre de revendications 1 à 9, caractérisé en ce que la section transversale des ouvertures (6, 7) correspond plus ou moins à 0,5 à 3 fois l'épaisseur de au moins une couche métallique (2).
